# EUROPÄISCHE PATENTSCHRIFT

(11) **EP 1 442 155 B1**
(45) Veröffentlichungstag und Bekanntmachung des Hinweises auf die Patenterteilung: **09.12.2009**
(21) Anmeldenummer: 02774761.7
(22) Anmeldetag: 31.10.2002
(51) Int. Cl.: C23F 1/00, C25F 3/02, H05K 3/07

(54) **VERFAHREN ZUR BEHANDLUNG VON ELEKTRISCH LEITFÄHIGEN SUBSTRATEN WIE LEITERPLATTEN UND DERGLEICHEN**
METHOD FOR THE TREATMENT OF ELECTRICALLY CONDUCTIVE SUBSTRATES AND PRINTED CIRCUIT BOARDS AND THE LIKE
PROCEDE DE TRAITEMENT DE SUBSTRATS ELECTROCONDUCTEURS TELS QUE DES PLAQUETTES OU SIMILAIRES

(30) Priorität: 05.11.2001 DE 10154886
(43) Veröffentlichungstag der Anmeldung: 04.08.2004
(73) Patentinhaber: Gebr. Schmid GmbH & Co., D-72250 Freudenstadt (DE)
(72) Erfinder: FAUSER, Heidi, 73529 Schwäbisch Gmünd (DE); ZIELONKA, Andreas, 73525 Schwäbisch Gmünd (DE); SCHMID, Christian, 72250 Freudenstadt (DE); ROGOLL, Volker, 73525 Schwäbisch Gmünd (DE); FREUDENBERGER, Renate, 71409 Schwaikheim (DE)
(74) Vertreter: Patentanwälte Ruff, Wilhelm, Beier, Dauster & Partner
(86) Internationale Anmeldenummer: PCT/EP2002/012153
(87) Internationale Veröffentlichungsnummer: WO 2003/041462

(56) Entgegenhaltungen:
- EP-A- 0 342 669
- DE-C- 19 831 330
- GB-A- 2 131 454
- US-A- 512 799
- US-A- 3 418 227
- US-A- 5 374 338
- US-B1- 6 365 057
- DATABASE CA [Online] CHEMICAL ABSTRACTS SERVICE, COLUMBUS, OHIO, US; YAMAMOTO, KAZUHITO ET AL: "Preparation of support for lithographic plates" retrieved from STN Database accession no. 121:69633 CA XP002243259 & JP 06 092052 A (TOKYO OHKA KOGYO CO LTD, JAPAN) 5. April 1994 (1994-04-05)
- DATABASE CA [Online] CHEMICAL ABSTRACTS SERVICE, COLUMBUS, OHIO, US; MITSUBISHI ALUMINUM CO., LTD., JAPAN: "Surface film formation on aluminum and aluminum alloys" retrieved from STN Database accession no. 100:199855 CA XP002243260 & JP 59 001699 A (MITSUBISHI ALUMINUM CO., LTD., JAPAN) 7. Januar 1984 (1984-01-07)
- DATABASE CA [Online] CHEMICAL ABSTRACTS SERVICE, COLUMBUS, OHIO, US; KAWADA, JUNICHIRO: "Etching germanium-indium alloyed junction element. I. Alkaline electrolytic etching combined with acid chemical etching for germanium-indium alloyed junction element" retrieved from STN Database accession no. 71:96238 CA XP002243261 & KINZOKU HYOMEN GIJUTSU (1969), 20(7), 341-7 , 1969,

## Beschreibung

Die Erfindung betrifft ein Verfahren zur Behandlung von elektrisch leitfähigen Substraten wie Leiterplatten, gedruckten Schaltungen und dergleichen, bei dem Kupfer teilweise abgetragen wird.

Bekanntermaßen besteht in der Elektronikindustrie die Notwendigkeit, Komponenten mit sehr kleinen Abmessungen herzustellen. Dies betrifft beispielsweise auch die Leiterbahnen von Leiterplatten, gedruckten Schaltungen und dergleichen. Hier ist es heutzutage ohne weiteres möglich, Strukturen mit Breiten und Tiefen im Bereich von Mikrometern, teilweise sogar von < 1 µm herzustellen. Dazu ist es auch erforderlich, Metallschichten selektiv und zuverlässig abzutragen.

Bei dem auch als Ätzen bezeichneten Abtrag der Metalle treten jedoch häufig Probleme auf. Ein besonders wichtiges Problem ist hier das sogenannte Unterätzen (englisch: underetching). So werden die Stellen des Substrats, an denen kein Abtrag des Metalls stattfinden soll, mit einer Schutzschicht, dem sogenannten Resist versehen. Dieser Resist kann als sogenannter Photoresist aus organischem Polymermaterial oder auch aus Metallschichten (z. B. Zinn oder Zinn/Blei) bestehen. Wird nun das Metall neben oder zwischen den Stellen, die mit dem Resist abgedeckt sind, abgetragen, so erfolgt dieser Abtrag nicht nur in die Tiefe (anisotrop), sondern "in alle Richtungen" (isotrop). Dies bedeutet, daß durch "Unterätzen" auch unter dem Resist Metall abgetragen wird.

Das Unterätzen führt nicht nur zu einem undefinierten Metallabtrag an den seitlichen Begrenzungen der entstehenden Struktur, sondern auch dazu, daß häufig keine Struktur erzeugt werden kann, die eine größere Tiefe als Breite aufweist.

Grundsätzlich sind verschiedene Methoden bekannt, um bei Leiterplatten und dergleichen Metallschichten abzutragen/abzuätzen. So gibt es auf der einen Seite Methoden, die ohne Verwendung eines flüssigen Mediums auskommen. Hier können das Ionenstrahlätzen und das Plasmaätzen als Beispiele genannt werden. Mit diesen Methoden ist ein weitgehend anisotroper Abtrag von Metallen möglich. Allerdings ist die technische Ausrüstung, die zur Durchführung dieser Verfahren benötigt wird, vergleichsweise aufwendig und teuer. Außerdem können durch diese Verfahren Verunreinigungen auf das Substrat gelangen, die ggf. mit aufwendigen Reinigungsverfahren wieder entfernt werden müssen.

Auf der anderen Seite sind Verfahren zum Abtragen von Metallen bekannt, die mit einem flüssigen Medium arbeiten. Hier handelt es sich insbesondere um das sogenannte chemische Ätzen und das sogenannte elektrochemische Ätzen. Beim chemischen Ätzen wird ein Ätzmittel in flüssiger Lösung eingesetzt, das das Metall durch eine chemische Reaktion abträgt. Dieses Abtragen erfolgt isotrop. Beim elektrochemischen Ätzen wird ein Elektrolyt verwendet, der im Regelfall nicht in der Lage ist, das Metall durch eine chemische Reaktion abzutragen, d. h. durch bloßen Kontakt mit dem Substrat. Beim elektrochemischen Ätzen wird zwischen dem Substrat und einer in den Elektrolyt eintauchenden Elektrode eine elektrische Spannung angelegt. Dabei wird das Substrat üblicherweise als Anode und die andere Elektrode als Kathode geschaltet. Durch die elektrische Spannung und das dadurch erzeugte elektrische Feld werden Ionen gebildet, die dann das Metall durch eine im wesentlichen chemische Reaktion abtragen.

Das elektrochemische Ätzen hat teilweise einen anisotropen Charakter, kann jedoch die Anisotropie bei den zuerst genannten Methoden wie Ionenstrahlätzen und Plasmaätzen nicht erreichen.

Im Ergebnis ist deshalb festzustellen, daß der grundsätzlich bekannte Stand der Technik zur Herstellung kleiner Strukturen auf Leiterplatten und dergleichen keine umfassend befriedigenden Lösungen bietet. Dementsprechend wurden in der Vergangenheit auch vergleichsweise komplizierte Lösungen gesucht, um die geschilderten Probleme zu vermeiden. So schlägt beispielsweise die WO98/10121 vor, ein Ätzmittel, das in konzentrierter Lösung chemisch ätzt, in sehr verdünnter Lösung für das elektrochemische Ätzen einzusetzen. Dies führt zu geringen Konzentrationen an Ätzmittel, die im industriellen Einsatz schwer handhabbar sind. Die WO99/45179 beschreibt ein Verfahren, bei dem unter anderem eine Gegenelektrode verwendet wird, deren Struktur bzw. Muster der Struktur bzw. dem Muster des zu behandelnden Substrats entspricht. Diese aufwendige Gestaltung der Gegenelektrode macht das Verfahren für den industriellen Einsatz ebenfalls nur bedingt geeignet.

Das Dokument D1 (D1: DATABASE CA [Online] CHEMICAL ABSTRACTS SERVICE, COLUMBUS, OHIO, US; YAMAMOTO, KAZUHITO ET AL: "Preparation of support for lithographic plates" XP002243259, STN Database accession no. 121:69633 CA) offenbart ein Verfahren zur Behandlung von elektrisch leitfähigen Substraten, wie Aluminiumplatten, bei dem das Aluminium abgetragen wird, wobei im ersten Verfahrensschritt das Metall elektrochemisch unter Anlegen eines gepulsten elektrischen Feldes und im darauffolgenden Verfahrensschritt chemisch abgetragen wird. Weiterhin offenbart D1, dass das elektrochemische Ätzen in einem sauren Elektrolyt, wie z.B. Salzsäure (HCl) oder Salpetersäure (HNO₃) unter Anlegen eines rechteckförmigen spannungsgepulsten elektrischen Feldes durchgeführt wird.

Das Dokument D2 (D2: DATABASE CA [Online] CHEMICAL ABSTRACTS SERVICE, COLUMBUS, OHIO, US; MITSUBISHI ALUMINUM CO., LTD., JAPAN: "Surface film formation on aluminum and aluminum alloys" XP002243260, STN Database accession no. 100:199855 CA) offenbart ein Verfahren zur Behandlung von elektrisch leitfähigen Substraten, wie Aluminium oder deren Legierungen, bei dem das Aluminium abgetragen wird, wobei im ersten Verfahrensschritt das Metall elektrochemisch unter Anlegen eines gepulsten elektrischen Feldes und im darauffolgenden Verfahrensschritt chemisch abgetragen wird. Außerdem offenbart D2, dass das elektrochemische Abtragen unter Anlegen eines gepulsten elektrischen Feldes in einem sauren Elektrolyt, wie z.B. 0,5-10 Gew. % Salzsäure (HCl) bei einer Temperatur zwischen 20 and 80 °C, durchgeführt wird. Das chemische Ätzen ohne elektrisches Feld erfolgt durch die Behandlung mit einer sauren wässrigen Lösung von HCl, H₂SO₄, HF oder HNO₃.

Die Erfindung stellt sich dementsprechend die Aufgabe, ein Verfahren der eingangs genannten Art zur Verfügung zu stellen, bei dem die geschilderten Nachteile vermieden oder doch wesentlich reduziert werden. Insbesondere soll die Erscheinung des Unterätzens in den Hintergrund gedrängt und damit ein weitgehend anisotropes Abtragen des Kupfers ermöglicht werden. Dabei soll auf vergleichsweise einfache und kostengünstige Methoden zurückgegriffen werden, die eine industrielle Verwendung des Verfahrens erlauben.

Diese Aufgabe wird gelöst durch das Verfahren mit den Merkmalen des Anspruchs 1. Bevorzugte Ausführungen dieses Verfahrens sind in den abhängigen Ansprüchen 2 bis 19 genannt. Der Wortlaut sämtlicher Ansprüche wird hiermit durch Bezugnahme zum Inhalt dieser Beschreibung gemacht.

Das eingangs genannte Verfahren zeichnet sich erfindungsgemäß dadurch aus, daß das abzutragende Kupfer zunächst in mindestens einem Verfahrensschritt elektrochemisch unter Anlegen eines gepulsten elektrischen Feldes abgetragen wird und in mindestens einem darauffolgenden Verfahrensschritt chemisch ohne elektrisches Feld abgetragen wird. Die Erfindung kann also als Kombination eines gepulsten elektrochemischen Ätzens und eines chemischen Nachätzens beschrieben werden. Obwohl es grundsätzlich möglich ist, zum Abtragen des Kupfers weitere Vorbehandlungs-, Zwischenbehandlungs- und Nachbehandlungsschritte durchzuführen, besteht das erfindungsgemäße Verfahren vorzugsweise ausschließlich aus der Abfolge der beiden genannten Schritte.

Überraschenderweise wird durch die gewählte Kombination der beiden Verfahrensschritte ein weitgehend anisotroper Abtrag des Kupfers ermöglicht. . Der erste Verfahrensschritt des gepulsten elektrochemischen Ätzens führt zu einem weitgehend anisotropen Abtrag in die Tiefe, wobei durch das Pulsen der Abtrag an den Seitenflächen benachteiligt und damit das Unterätzen reduziert ist. Der zweite Verfahrensschritt des chemischen Nachätzens bewirkt, daß die restliche verbliebene Metallschicht am Grund der durch den ersten Schritt erzeugten Struktur noch abgetragen wird. Da es sich hier nur noch um vergleichsweise geringe Mengen an abzutragendem Material handelt, kann der isotrope Charakter des chemischen Ätzens in Kauf genommen werden.

Bekanntlich kann ein gepulstes elektrisches Feld sowohl durch einen entsprechenden Strompuls als auch durch einen entsprechenden Spannungspuls erzeugt werden. Es ist erfindungsgemäß bevorzugt, wenn ein Spannungspuls verwendet wird. Dies hat zur Folge, daß sich der Strom währenddessen frei ändern kann. Grundsätzlich können die verschiedensten Pulsformen verwendet werden, wie sie dem Fachmann aus entsprechenden Lehrbüchern bekannt sind. Bei dem erfindungsgemäßen Verfahren wird vorzugsweise mit rechteckförmigen Spannungspulsen gearbeitet. Die Rechteckpulse werden dabei so ausgeführt, daß zwischen der maximalen Spannung und der Spannung 0 V hin- und hergeschaltet wird. Während der Dauer des Pulses liegt also die maximale Spannung an, in den Pulspausen ist die Spannung vollständig abgeschaltet.

Bei bevorzugten Ausführungsformen der Erfindung beträgt die (maximale) Spannung 5 V bis 20 V, wobei Spannungswerte zwischen 8 V und 12 V bevorzugt sind. Innerhalb des zuletzt genannten Bereiches sind Spannungswerte von ca. 10 V als besonders bevorzugt hervorzuheben.

Die Zeitdauer der angelegten Spannung, die sogenannte Anzeit, und die Zeitdauer der Pulspausen, die sogenannte Auszeit, sind grundsätzlich frei wählbar. Es ist allerdings bevorzugt, wenn die Anzeit zwischen 2 ms und 20 ms, vorzugsweise zwischen 5 ms und 15 ms, gewählt wird. Ein weiter bevorzugter Wert für die Anzeit sind ca. 10 ms. Bei der Auszeit sind Zeitdauern zwischen 50 ms und 250 ms, insbesondere zwischen 80 ms und 150 ms, bevorzugt. Insbesondere ist hier ein Wert von 90 ms für die Auszeit zu nennen. Es hat sich gezeigt, daß bei bevorzugten Ausführungsformen die Pulspausen nicht zu kurz gewählt werden sollten. Das Verhältnis von Auszeit zu Anzeit kann deshalb vorzugsweise > 5:1, insbesondere > 10:1, sein.

Der Verfahrensschritt des gepulsten elektrochemischen Ätzens wird vorzugsweise in einem sauren Elektrolyten durchgeführt, der selbst nur eine geringe oxidierende Wirkung besitzt. Dies bedeutet, daß dieser Elektrolyt für ein chemisches Ätzen (ohne elektrisches Feld) nicht geeignet ist, da er mit dem abzutragenden Metall keine chemische Reaktion eingeht. Ein solcher saurer Elektrolyt ist vorzugsweise Schwefelsäure, insbesondere 1,63-molare Schwefelsäure. Auch Methansulfonsäure ist als ein solcher Elektrolyt zu nennen.

Der Verfahrensschritt des gepulsten elektrochemischen Ätzens wird bei der Erfindung vorzugsweise bei höherer Temperatur als Raumtemperatur durchgeführt. Vorzugsweise wird die Temperatur zwischen 30°C und 60°C gewählt. Innerhalb dieses Bereichs sind Temperaturen zwischen 40°C und 50°C bevorzugt. Bei diesen erhöhten Temperaturen erfolgt ein beschleunigter anisotroper Abtrag des Metalls.

Bei der Erfindung erfolgt der Verfahrensschritt des gepulsten elektrochemischen Ätzens vorzugsweise über eine Zeitdauer zwischen 10 s und 100 s, vorzugsweise zwischen 20 s und 60 s. Bei weiter bevorzugten Ausführungsformen werden Zeitdauern zwischen 30 s und 40 s gewählt.

Der darauffolgende Verfahrensschritt des chemischen Ätzens ist vom Grundsatz her aus dem Stand der Technik bekannt. Der Abtrag erfolgt durch Kupfer selbst. Als Ätzmittel wird Kupferchlorid (CuCl₂) in salzsaurer Lösung verwendet. Dadurch wird das metallische Kupfer des Substrats zu Cu(I) oxidiert und das im Ätzmittel enthaltene Cu(II) zu Cu(I) reduziert. Die entsprechenden Mechanismen sind dem Fachmann bekannt. Das Kupfer ist in der verwendeten Lösung in Konzentrationen zwischen 80 g/l und 150 g/l enthalten. Vorzugsweise werden Konzentrationen von ca. 120 g/l verwendet. Für die in der Lösung ebenfalls enthaltene Salzsäure (HCl) gelten die gleichen Konzentrationsbereiche bzw. die weiter bevorzugte Konzentration von ca. 120 g/l.

Auch beim chemischen Ätzen ist es bevorzugt, wenn bei höheren Temperaturen als Raumtemperatur gearbeitet wird, da auch hier die Reaktion entsprechend beschleunigt werden kann. Als bevorzugte Temperaturbereiche sind hier 40°C bis 70°C, insbesondere 50°C bis 60°C, hervorzuheben.

Die Zeitdauer, während der der nachfolgende Verfahrensschritt des chemischen Ätzens durchgeführt wird, ist ebenfalls grundsätzlich frei wählbar. Erfindungsgemäß sind jedoch Zeitdauern für das chemische Ätzen von > 5 s, vorzugsweise 10 s bis 100 s, bevorzugt. Weiter bevorzugt ist es, wenn das chemische Ätzen über einen Zeitraum von 10 s bis 40 s durchgeführt wird.

Wie oben bereits ausgeführt, kann das erfindungsgemäße Verfahren auch als Kombination eines gepulsten elektrochemischen (Vor-)Ätzens mit nachfolgendem chemischen (Nach-)Ätzen beschrieben werden. Beim gepulsten elektrochemischen Ätzen erfolgt der Kupferabtrag weitgehend anisotrop in die Tiefe, beim chemischen Nachätzen wird die verbliebene Restkupferschicht abgetragen. In Übereinstimmung mit diesem erfindungsgemäßen Prinzip ist es bevorzugt, wenn bei der Erfindung durch das gepulste elektrochemische Ätzen > 80 %, vorzugsweise > 90 %, der abzutragenden Kupferschicht (Schichtdicke) abgetragen/ abgeätzt werden. Der verbleibende Rest von < 20 % der Schichtdicke, vorzugsweise < 10 % der Schichtdicke, wird dann durch das chemische Ätzen abgetragen. Es ist deshalb weiter bevorzugt, wenn durch den Verfahrensschritt des gepulsten elektrochemischen Ätzens die zu beseitigende Schichtdicke des Metalls bis auf < 5 µm, vorzugsweise bis auf < 2 µm, abgetragen wird. Bei diesen bevorzugten beschriebenen Ausführungsformen kommen die erfindungsgemäßen Vorteile besonders gut zum Tragen.

Besonders hervorzuheben ist noch, daß das erfindungsgemäße Verfahren insbesondere zur Behandlung/Bearbeitung von Leiterplatten und dergleichen geeignet ist, bei denen durch Kupferabtrag Strukturen mit Abmessungen von < 25 µm, vorzugsweise von < 10 µm, erzeugt werden sollen. Es lassen sich dementsprechend nämlich solche Strukturen erzeugen, bei denen die betreffende Struktur eine größere Tiefe als Breite aufweist.

Außerdem ist noch zu betonen, daß bei dem erfindungsgemäßen Verfahren eine Regeneration des abgetragenen Kupfers auf einfache Weise möglich ist, so wird das metallische Kupfer beim Abtrag als Ion in Lösung überführt. Dieses Kupfer in ionischer Form kann bei anderen Verfahrensschritten bei der Behandlung von Leiterplatten verwendet werden. Insbesondere kann das Kupferion direkt wieder als metallisches Kupfer auf einer Leiterplatte abgeschieden werden. Die beim Abtrag des Kupfers erhaltenen Lösungen lassen sich also insbesondere im Kreislaufverfahren zu den entsprechenden anderen Verfahrensstationen bringen (und nach Abscheidung ggf. wieder zurück). Es ist auch möglich, das in ionischer Form enthaltene Kupfer zur weiteren Verwendung an einer kathodisch geschalteten Elektrode abzuscheiden und dann weiter zu verwenden.

Eine Vorrichtung zur Durchführung des beschriebenen erfindungsgemäßen Verfahrens, enthält übliche Komponenten, wie sie für ein elektrochemisches Ätzen und ein chemisches Ätzen notwendig sind. Hier handelt es sich insbesondere um einen geeigneten Behälter, in dem beispielsweise die Leiterplatte in die entsprechenden Lösungen eingebracht wird. Weiter ist eine Einrichtung vorhanden, mit deren Hilfe die Leiterplatte als Anode in einen entsprechenden Stromkreis geschaltet werden kann. Derartige Einrichtungen kontaktieren die Leiterplatte vorzugsweise an einer oder zwei ihrer Seiten. Andere Komponenten der Vorrichtung sind eine als Kathode in den Stromkreis schaltbare Elektrode, eine Strom- /Spannungs-quelle, Steuer- und Regeleinrichtungen, Thermostatisiereinrichtungen und dergleichen. Bei der Vorrichtung muß die Strom/Spannungsquelle bzw. die entsprechende Steuer- und Regeleinrichtung in der Lage sein, ein gepulstes elektrisches Feld, insbesondere Spannungspulse zu erzeugen.

Die genannten und weitere Merkmale der Erfindung ergeben sich aus dem folgenden Beispiel in Kombination mit den Unteransprüchen. Dabei können die erfindungsgemäßen Merkmale entweder für sich allein oder in Kombination miteinander verwirklicht sein.

### Beispiel

Eine dem Fachmann vom Grundsatz her bekannte Apparatur zum elektrochemischen und chemischen Ätzen weist einen Behälter auf, der mit den entsprechenden Flüssigkeiten befüllbar und durchströmbar ist.

Innerhalb des Behälters kann eine Leiterplatte kontaktiert und als Anode in einen Stromkreis geschaltet werden. Im eingebauten Zustand ist gegenüber der Leiterplatte eine als Kathode geschaltete Elektrode angeordnet. Die Form dieser Kathode ist allerdings nicht kritisch. Um den Behälter mit den entsprechenden Flüssigkeiten durchströmen zu können, ist eine Pumpe sowie ein Strömungsmesser vorgesehen. Mit Hilfe eines Thermostaten läßt sich die durch den Behälter geführte Flüssigkeit auf eine bestimmte Temperatur einstellen. Desweiteren ist eine Strom-/Span-nungsquelle mit Pulsgenerator zur Erzeugung der Spannungspulse vorhanden, sowie eine entsprechende Auswerteeinheit in Form eines Mikrocomputers.

In den Behälter wird eine Leiterplatte eingebracht, bei der auf den Polymer-Grundkörper eine durchgehende Kupferschicht aufgebracht wurde und bei der eine Leiterbahnstruktur durch Aufbringen eines üblichen Photoresist vorgegeben ist. Die Breite der entsprechenden Leiterbahnstruktur beträgt ca. 30 µm.

Mit der beschriebenen Leiterplatte wird nun das erfindungsgemäße Verfahren durchgeführt. Dabei wird zunächst der Schritt des gepulsten elektrochemischen Ätzens durchgeführt. Als Elektrolyt wird 1,63-molare Schwefelsäure (entspricht 160 g/l) verwendet. Die Temperatur ist auf 40°C eingestellt. Es werden Rechteckspannungspulse von 10 V aufgegeben, wobei die Anzeit (10 V) jeweils 10 ms, die Auszeit (0 V) jeweils 90 ms beträgt. Das gepulste elektrochemische Ätzen wird über eine Zeitdauer von 35 s durchgeführt.

Anschließend wird der Verfahrensschritt des chemischen Ätzens angewendet. Als Ätzmedium dient hier eine Lösung, die 120 g/l Kupfer (als CuCl₂) und 120 g/l HCl enthält. Die Temperatur wird beim chemischen Ätzen auf 50°C eingestellt. Die Dauer des zweiten Verfahrensschritts beträgt 25 s.

Die Auswertung der Leiterplatte zeigt, daß ein weitgehend anisotroper Abtrag der Kupferschicht stattgefunden hat. Die Tiefe der abgetragenen Struktur beträgt ca. 17 µm. Der Effekt des Unterätzens ist vernachlässigbar. Verfolgt man das Tiefenprofil des Abtrags während der beiden erfindungsgemäßen Verfahrensschritte, so stellt man fest, dass bei dem geschilderten Beispiel ca. 15 µm durch das gepulste elektrochemische Ätzen abgetragen werden, und die restlichen 2 µm durch das chemische Ätzen.

## Patentansprüche

1. Verfahren zur Behandlung von elektrisch leitfähigen Substraten wie Leiterplatten, bei dem Kupfer teilweise abgetragen wird, wobei das Kupfer in einem ersten Verfahrensschritt elektrochemisch unter Anlegen eines gepulsten elektrischen Feldes und in einem darauffolgenden zweiten Verfahrensschritt chemisch ohne Anlegen eines elektrischen Feldes abgetragen wird, **dadurch gekennzeichnet, dass** das chemische Abtragen ohne elektrisches Feld durch sogenanntes CuCl₂-Ätzmittel in HCl erfolgt, wobei die Kupferkonzentration des Ätzmittels 80 g/l Cu bis 150 g/l Cu beträgt und wobei die HCl-Konzentration 80 g/l bis 150 g/l beträgt.

2. Verfahren nach Anspruch 1, **dadurch gekennzeichnet, dass** das gepulste elektrische Feld beim elektrochemischen Abtragen durch das Anlegen von Spannungspulsen erzeugt wird.

3. Verfahren nach Anspruch 1 oder Anspruch 2, **dadurch gekennzeichnet, dass** rechteckförmige Pulse, insbesondere Spannungspulse, angelegt werden.

4. Verfahren nach Anspruch 2 oder Anspruch 3, **dadurch gekennzeichnet, dass** die angelegte Maximalspannung 5 V bis 20 V, vorzugsweise 8 V bis 12 V, insbesondere 10 V, beträgt.

5. Verfahren nach einem der vorhergehenden Ansprüche, **dadurch gekennzeichnet, dass** die sogenannte Anzeit des elektrischen Feldes 2 bis 20 ms, vorzugsweise 5 bis 15 ms, insbesondere 10 ms, beträgt.

6. Verfahren nach einem der vorhergehenden Ansprüche, **dadurch gekennzeichnet, dass** die sogenannte Auszeit des angelegten elektrischen Feldes 50 bis 250 ms, vorzugsweise 80 bis 150 ms, insbesondere 90 ms, beträgt.

7. Verfahren nach einem der vorhergehenden Ansprüche, **dadurch gekennzeichnet, dass** das Verhältnis der sogenannten Auszeit des angelegten elektrischen Feldes zur sogenannten Anzeit des angelegten elektrischen Feldes > 5 : 1, vorzugsweise > 10 : 1, ist.

8. Verfahren nach einem der vorhergehenden Ansprüche, **dadurch gekennzeichnet, dass** das elektrochemische Abtragen unter Anlegen eines gepulsten elektrischen Feldes in einem sauren, im wesentlichen nicht oxidierenden Elektrolyten durchgeführt wird.

9. Verfahren nach Anspruch 8, **dadurch gekennzeichnet, dass** es sich bei dem Elektrolyten um Schwefelsäure, vorzugsweise 1,63 M-Schwefelsäure handelt.

10. Verfahren nach einem der vorhergehenden Ansprüche, **dadurch gekennzeichnet, dass** das elektrochemische Abtragen unter Anlegen eines gepulsten elektrischen Feldes bei einer Temperatur zwischen 30 °C und 60 °C, vorzugsweise zwischen 40 °C und 50 °C, durchgeführt wird.

11. Verfahren nach einem der vorhergehenden Ansprüche, **dadurch gekennzeichnet, dass** das elektrochemische Abtragen unter Anlegen eines gepulsten elektrischen Feldes über eine Zeitdauer von 10 s bis 100 s, vorzugsweise 20 s bis 60 s, insbesondere 30 s bis 40 s, erfolgt.

12. Verfahren nach einem der vorhergehenden Ansprüche, **dadurch gekennzeichnet, dass** das chemische Abtragen ohne elektrisches Feld bei einer Temperatur zwischen 40 °C bis 70 °C, vorzugsweise zwischen 50 °C und 60 °C, durchgeführt wird.

13. Verfahren nach einem der vorhergehenden Ansprüche, **dadurch gekennzeichnet, dass** das chemische Abtragen ohne elektrisches Feld über eine Zeitdauer von mehr als 5 s, vorzugsweise über eine Zeitdauer zwischen 10 s und 100 s, insbesondere zwischen 10 s und 40 s, durchgeführt wird.

14. Verfahren nach einem der vorhergehenden Ansprüche, **dadurch gekennzeichnet, dass** durch das elektrochemische Abtragen mindestens 80%, vorzugsweise mindestens 90%, der insgesamt abzutragenden Schichtdicke des Kupfers abgetragen werden, und dementsprechend vorzugsweise durch das chemische Abtragen < 20%, vorzugsweise < 10 %, der insgesamt abzutragenden Schichtdicke des Kupfers.

15. Verfahren nach einem der vorhergehenden Ansprüche, insbesondere nach Anspruch 14, **dadurch gekennzeichnet, dass** das Kupfer durch das elektrochemische Abtragen bis zu einer Restschichtdicke von < 5 µm, vorzugsweise < 2 µm, abgetragen wird, und die dann verbliebene Schichtdicke durch das chemische Abtragen abgetragen wird.

16. Verfahren nach einem der vorhergehenden Ansprüche, **dadurch gekennzeichnet, dass** durch das Abtragen des Kupfers auf dem Substrat Strukturen mit Abmessungen von < 25 µm, vorzugsweise von 10 µm, erzeugt werden.

17. Verfahren nach einem der vorhergehenden Ansprüche, **dadurch gekennzeichnet, dass** das bei einem der beiden Verfahrensschritte abgetragene Kupfer, vorzugsweise das bei beiden Verfahrensschritten abgetragene Kupfer für weitere Verfahrensschritte bei der Behandlung der elektrisch leitfähigen Substrate regeneriert wird.

18. Verfahren nach Anspruch 17, **dadurch gekennzeichnet, dass** das abgetragene Kupfer im Kreislaufverfahren in die genannten weiteren Verfahrensschritte eingebracht wird.

19. Verfahren nach Anspruch 17 oder Anspruch 18, **dadurch gekennzeichnet, dass** das abgetragene Kupfer in metallischer Form regeneriert wird, vorzugsweise durch Abscheidung des Kupfers in metallischer Form an einer Elektrode.

## Claims

1. A method for the treatment of electrically conductive substrates and printed circuit boards, wherein copper is partially removed, the copper being removed in a first step including an electrochemical erosion procedure by applying a pulsed electrical field, and in a subsequent second step including a chemical erosion procedure without applying an electrical field, **characterized in that** chemical erosion without an electrical field is performed using a so-called CuCl₂ etchant in HCl, the copper concentration of the etchant ranging from 80 g/l Cu to 150 g/l Cu, and the HCl concentration ranging from 80 g/l to 150 g/l.

2. The method according to claim 1, **characterized in that** during electrochemical erosion the pulsed electrical field is generated by applying voltage pulses.

3. The method according to claim 1 or claim 2, **characterized in that** square wave pluses, in particular voltage pulses are applied.

4. The method according to claim 2 or claim 3, **characterized in that** a maximum voltage applied is 5 V to 20 V, preferred 8 V to 12 V, in particular 10 V.

5. The method according to any of the preceding claims, **characterized in that** the so-called on-time of the electrical field is 2 to 20 ms, preferred 5 to 15 ms, in particular 10 ms.

6. The method according to any of the preceding claims, **characterized in that** the so-called off-time of the electrical field is 50 to 250 ms, preferred 80 to 150 ms, in particular 90 ms.

7. The method according to any of the preceding claims, **characterized in that** the ratio of the so-called off-time of the applied electrical field to the so-called on-time of the applied electrical field is more than 5:1, preferred more than 10 : 1.

8. The method according to any of the preceding claims, **characterized in that** the electrochemical erosion by applying a pulsed electrical field is performed in an acid, essentially non-oxidizing electrolyte.

9. The method according to claim 8, **characterized in that** the electrolyte is sulfuric acid, preferred 1.63 M sulfuric acid.

10. The method according to any of the preceding claims, **characterized in that** the electrochemical erosion by applying a pulsed electrical field is performed at a temperature from 30 °C to 60 °C, preferred from 40 °C to 50 °C.

11. The method according to any of the preceding claims, **characterized in that** the electrochemical erosion by applying a pulsed electrical field is performed for a time period from 10 s to 100 s, preferred from 20 s to 60 s, in particular from 30 s to 40 s.

12. The method according to any of the preceding claims, **characterized in that** the chemical erosion without an electrical field is performed at a temperature from 40 °C to 70 °C, preferred from 50 °C to 60 °C.

13. The method according to any of the preceding claims, **characterized in that** the chemical erosion without an electrical field is performed for a time period from 10 s to 100 s, in particular from 10 s to 40 s.

14. The method according to any of the preceding claims, **characterized in that** at least 80 %, preferred at least 90 % of the total film thickness of copper to be removed are removed by electrochemical erosion, and thus less than 20 %, preferred less than 10 % of the total film thickness of copper to be removed are removed by chemical erosion.

15. The method according to any of the preceding claims, in particular according to claim 14, **characterized in that** the copper is removed by electrochemical erosion to a remaining film thickness of less than 5 µm, preferred less than 2 µm, and then the remaining film thickness is removed by chemical erosion.

16. The method according to any of the preceding claims, **characterized in that** structures having dimensions of less than 25 µm, preferred less than 10 µm are produced by removing of copper on the substrate.

17. The method according to any of the preceding claims, **characterized in that** the copper removed in any of the two procedure steps, preferably the copper removed in both the procedure steps is regenerated for further procedure steps in the treatment of electrically conductive substrates.

18. The method according to claim 17, **characterized in that** the removed copper is introduced into said further procedure steps by a cycling process.

19. The method according to claim 17 or claim 18, **characterized in that** the removed copper is regenerated in metallic form, preferred by depositing metallic copper onto an electrode.

## Revendications

1. Procédé pour le traitement de substrats électroconducteurs, tels que des cartes de circuits imprimés, dans lequel une partie du cuivre est enlevée, sachant que dans une première phase du procédé le cuivre est enlevé de façon électrochimique en appliquant un champ électrique pulsé et que dans une deuxième phase successive du procédé le cuivre est enlevé de façon chimique sans appliquer un champ électrique, **caractérisé en ce que** l'enlèvement chimique sans application d'un champ électrique est effectué par une solution d'attaque au CuCl₂ dans HCl, sachant que la concentration de cuivre dans la solution d'attaque comporte entre 80 g/l et 150 g/l de Cu et sachant que la concentration de HCl comporte entre 80 g/l et 150 g/l.

2. Procédé d'après la revendication 1, **caractérisé en ce que** le champ électrique pulsé pendant l'enlèvement électrochimique est réalisé par l'application d'impulsions de tension.

3. Procédé d'après la revendication 1 ou 2, **caractérisé en ce qu'**on applique des impulsions rectangulaires, notamment des impulsions de tension.

4. Procédé d'après la revendication 2 ou 3, **caractérisé en ce que** la tension maximale appliquée comporte entre 5 V et 20 V, de préférence entre 8 V et 12 V, notamment 10 V.

5. Procédé d'après une des revendications précédentes, **caractérisé en ce que** chaque durée d'application de la tension d'impulsion du champ électrique comporte entre 2 et 20 ms, de préférence entre 5 et 15 ms, notamment 10 ms.

6. Procédé d'après une des revendications précédentes, **caractérisé en ce que** chaque durée des pauses d'impulsion du champ électrique comporte entre 50 et 250 ms, de préférence entre 80 et 150 ms, notamment 90 ms.

7. Procédé d'après une des revendications précédentes, **caractérisé en ce que** le taux de durée pause-impulsion du champ électrique appliqué > 5 : 1, de préférence > 10 : 1.

8. Procédé d'après une des revendications précédentes, **caractérisé en ce que** l'enlèvement électrochimique est effectué en appliquant un champ électrique pulsé dans un électrolyte acide essentiellement non-oxydant.

9. Procédé d'après la revendication 8, **caractérisé en ce que** l'électrolyte est de l'acide sulfurique, de préférence de l'acide sulfurique 1,63 M.

10. Procédé d'après une des revendications précédentes, **caractérisé en ce que** l'enlèvement électrochimique est effectué en appliquant un champ électrique pulsé à une température qui s'élève à une valeur entre 30 °C et 60 °C, de préférence entre 40 °C et 50 °C.

11. Procédé d'après une des revendications précédentes, **caractérisé en ce que** l'enlèvement électrochimique est effectué en appliquant un champ électrique pulsé pendant une durée comportant une valeur entre 10 s et 100 s, de préférence entre 20 s et 60 s, notamment entre 30 s et 40 s.

12. Procédé d'après une des revendications précédentes, **caractérisé en ce que** l'enlèvement chimique sans champ électrique est effectué à une température qui s'élève à une valeur entre 40 °C et 70 °C, de préférence entre 50 °C et 60 °C.

13. Procédé d'après une des revendications précédentes, **caractérisé en ce que** l'enlèvement chimique sans champ électrique est effectué pendant une durée comportant une valeur de plus de 5 s, de préférence une valeur entre 10 s et 100 s, notamment entre 10 s et 40 s.

14. Procédé d'après une des revendications précédentes, **caractérisé en ce qu'**au moins 80 % et de préférence au moins 90 % de l'épaisseur de la couche de cuivre à enlever au total est enlevé par voie électrochimique et que par conséquent < 20 %, de préférence < 10 % de l'épaisseur de la couche de cuivre à enlever au total est enlevée par la voie chimique.

15. Procédé d'après une des revendications précédentes et notamment d'après la revendication 14, **caractérisé en ce que** par voie électrochimique le cuivre est enlevé jusqu'à une épaisseur de couche résiduelle comportant < 5 µm, de préférence < 2 µm, et qu'en suite la couche résiduelle est enlevée par voie chimique.

16. Procédé d'après une des revendications précédentes, **caractérisé en ce que** par l'enlèvement du cuivre situé sur le substrat on réalise des structures présentant des dimensions < 25 µm, de préférence < 10 µm.

17. Procédé d'après une des revendications précédentes, **caractérisé en ce que** le cuivre enlevé par une des deux phases de procédé, de préférence par les deux phases de procédé est régénéré pour d'autres phases de procédé pour le traitement des substrats électroconducteurs.

18. Procédé d'après la revendication 17, **caractérisé en ce que** le cuivre enlevé est introduit par un procédé cyclique dans les autres phases de procédé nommées.

19. Procédé d'après la revendication 17 ou 18, **caractérisé en ce que** le cuivre enlevé est régénéré sous forme métallique, de préférence par dépôt du cuivre sous forme métallique sur une électrode.
